# FASCICULE DE BREVET EUROPEEN

(11) **EP 1 393 248 B1**
(45) Date de publication et mention de la délivrance du brevet: **21.11.2012**
(21) Numéro de dépôt: 02730406.2
(22) Date de dépôt: 14.05.2002
(51) Int. Cl.: G06K 19/077

(54) **PROCEDE DE FABRICATION D'UNE CARTE A PUCE SANS CONTACT A L'AIDE DE PAPIER TRANSFERT**
HERSTELLUNGSVERFAHREN EINER KONTAKTLOSEN IC KARTE MIT EINEM TRANSFERPAPIER
METHOD FOR PRODUCING A CONTACTLESS CHIP CARD USING TRANSFER PAPER

(30) Priorité: 16.05.2001 FR 0106480
(43) Date de publication de la demande: 03.03.2004
(73) Titulaire: ASK S.A., 06560 Valbonne (FR)
(72) Inventeur: HALOPE, Christophe, F-06220 Golfe Juan (FR)
(86) Numéro de dépôt international: PCT/FR2002/001625
(87) Numéro de publication internationale: WO 2002/093472

(56) Documents cités:
- EP-A- 0 920 056
- WO-A-00/22673
- FR-A1- 2 764 414

## Description

### Domaine technique

La présente invention concerne le domaine des cartes (ou tickets) à puce et plus particulièrement un procédé de fabrication d'une carte à.puce sans contact.

### Etat de la technique

Les cartes et tickets à puce, et plus particulièrement les cartes au format ISO, sont devenues aujourd'hui incontournables. Outre leur utilisation comme cartes de crédit, ces dernières sont devenues des outils indispensables dans de nombreux domaines. Ce développement s'explique notamment par le fait que, outre l'utilisation classique de la carte par contact avec son lecteur associé, telle que la carte bancaire ou la carte de téléphone, les cartes peuvent désormais être utilisées sans aucun contact physique avec leurs lecteurs.

En effet, l'échange d'informations entre une carte sans contact ou hybride contact-sans contact et le dispositif de lecture associé s'effectue par couplage électromagnétique à distance entre une antenne logée dans la carte sans contact et une deuxième antenne située dans le lecteur. Pour élaborer, stocker et traiter les informations, la carte est munie d'une puce, qui est reliée à l'antenne. L'antenne se trouve généralement sur un support diélectrique en matière plastique. Cette facilité d'utilisation a grandement permis le développement d'autres applications. Ainsi, a-t-on vu apparaître le porte-monnaie électronique. Dans le secteur des transports, la carte à puce a été développée comme moyen de paiement autoroutier. Dans le domaine des loisirs, elle est utilisée par les supporters comme carte d'abonnement aux stades. Dans le domaine de la sécurité, de nombreuses sociétés ont mis en place un système d'identification de leur personnel par carte à puce ISO sans contact.

Les cartes sans contact que l'on trouve classiquement sur le marché sont constituées de plusieurs couches de matière plastique, notamment de polychlorure de vinyle (PVC). ,Parmi ces couches, une couche constitue le support de l'antenne de la carte, les autres couches constituant généralement les corps de carte. L'antenne de la carte est généralement une antenne en cuivre filaire ou une antenne gravée chimiquement.

Toutefois, ce type de carte est relativement coûteux à produire. En effet, l'utilisation du cuivre ou de la gravure a un coût conséquent. De plus, la réalisation d'une telle antenne sur un support en PVC nécessite l'utilisation de machines sophistiquées et donc chères.

Or, le développement de la technologie sans contact passe par une réduction des coûts de fabrication de ce type de carte. Un moyen de réduire ces coûts consiste à utiliser de procédés de fabrication de l'antenne moins coûteux et notamment en réalisant cette dernière par sérigraphie d'une encre conductrice.

Toutefois la sérigraphie sur le PVC possède plusieurs inconvénients. En effet, les propriétés thermomécaniques du PVC sont médiocres. Lors de la lamination des corps de carte, le fluage de matière est très important et le facteur de forme de l'antenne n'est pas conservé. Avant lamination, lors du sèchage de l'encre conductrice constituant l'antenne, la température étant supérieure à la température de ramollissement de la matière thermoplastique, il y a déformation du support modifiant les paramètres électriques de l'antenne. Ces inconvénients entraînent un dysfonctionnement de l'antenne car les paramètres électriques (inductance et résistance) varient. Plus grave, il n'est pas rare d'observer des coupures d'antenne aux endroits où les contraintes de cisaillement sont fortes. En outre, il n'est pas possible de remplacer la matière thermoplastique par une matière thermodurcissable dans la mesure où cette dernière ne peut pas être laminée à chaud

Un autre inconvénient est que lorsque l'antenne est sérigraphiée sur du PVC, la connexion de la puce sur l'antenne est beaucoup lus difficile à réaliser.

### Exposé de l'invention

Le but de l'invention est donc de pallier ces inconvénients en fournissant un procédé de fabrication permettant d'obtenir une carte à puce sans contact, en matière plastique, avec une antenne en encre sérigraphiée, dont le coût de revient est faible et qui possède une grande fiabilité.

L'invention concerne donc un procédé de fabrication d'une carte à puce sans contact comportant les étapes suivantes :
- fabrication de l'antenne consistant à sérigraphier des spires d'encre conductrice polymérisable sur un papier transfert et à faire subir à ce papier transfert un traitement thermique de façon à cuire et polymériser l'encre conductrice,
- connexion d'une puce, munie de plots de connexions, sur l'antenne,
- lamination consistant à solidariser le papier transfert avec une couche de matière plastique constituant le support d'antenne, par pressage à chaud, de façon à ce que l'antenne et la puce soit noyées dans la couche de matière plastique,
- décollage du papier transfert, et
- lamination de corps de carte sur le support d'antenne, consistant à souder de chaque côté du support au moins une couche de matière plastique, par pressage à chaud.

Un autre objet de l'invention est une carte à puce, obtenue par le procédé selon l'invention, comprenant un support d'antenne en matière plastique et au moins une couche de matière plastique de chaque côté du support d'antenne constituant les corps de carte, dans laquelle l'antenne sérigraphiée et la puce sont noyées dans le support d'antenne.

### Description brève des figures

Les buts, objets et caractéristiques de l'invention ressortiront mieux à la lecture de la description qui suit faite en référence aux dessins joints dans lesquels :
La figure 1 représente une vue de face d'une feuille de papier transfert portant une antenne sérigraphiée et une puce connectée à cette antenne.
La figure 2 représente une coupe longitudinale selon l'axe A-A de la feuille de papier transfert représentée sur la figure 1.
La figure 3 représente une coupe longitudinale de la feuille de papier transfert solidaire d'un support d'antenne en matière plastique après une étape de lamination.
La figure 4 représente une coupe longitudinale du support d'antenne après l'étape de décollage de la feuille de papier transfert.
La figure 5 représente une coupe longitudinale de la carte à puce selon l'invention, une fois achevée.

### Description détaillée de l'invention

La première étape du procédé de fabrication de la carte à puce selon l'invention consiste à réaliser une antenne sur un support approprié qui est une feuille de papier transfert. L'antenne est préférentiellement obtenue par sérigraphie d'une encre conductrice sur cette feuille de papier transfert. Cette antenne est constituée de spires concentriques et de deux plots de connexion sérigraphiés. Les plots de connexion permettent la connexion entre la puce et l'antenne. Une fois l'antenne réalisée, le papier transfert subit un traitement thermique permettant de cuire l'encre sérigraphiée. L'encre utilisée est un encre polymère chargée en éléments conducteurs. Il s'agit préférentiellement d'une encre époxy chargée en particules d'argent, de cuivre ou de carbone.

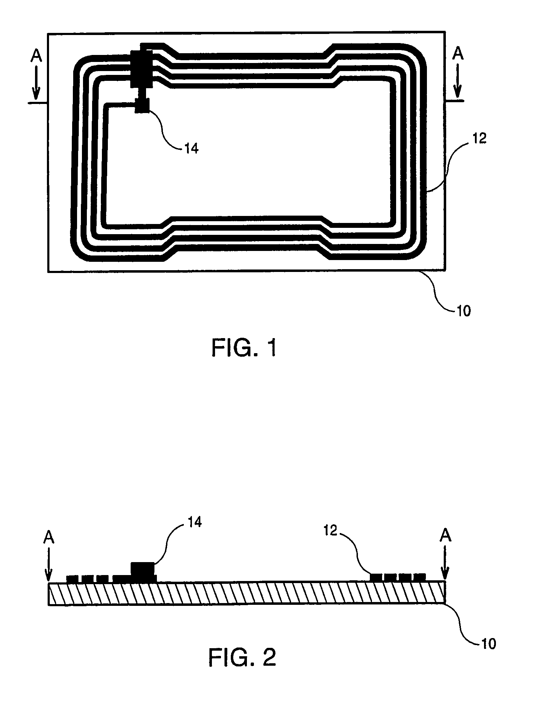

Une fois l'antenne réalisée, la puce est connectée à cette dernière sur la feuille de papier transfert. La feuille de papier transfert 10 portant l'antenne 12 sérigraphiée et la puce 14, connectées entre elles, est représentée sur la figure 1. Plusieurs méthodes peuvent être utilisées pour connecter la puce 14 sur l'antenne 12. Un premier mode de réalisation comprend les étapes suivantes :
- positionner la puce sur le papier transfert de manière à ce que les plots de connexion de la puce soient en regard des plots de connexion de l'antenne, et
- exercer une pression sur la puce de façon à ce que ses plots de connexion déforment la feuille de papier transfert et les plots de connexion de l'antenne sous l'effet de la pression. La feuille de papier transfert et les plots de connexion de l'antenne conservent leur déformation après que la pression a cessé d'être exercée, permettant ainsi d'obtenir une surface de contact importante entre les plots de connexion de la puce et les plots de connexion de l'antenne.

Selon un second mode de réalisation, la connexion de la puce comprend les étapes suivantes :
- enduire les plots de connexion de l'antenne d'une colle conductrice et
- positionner la puce sur la feuille de papier transfert de manière à ce que les plots de connexion de ladite puce viennent baigner dans ladite colle conductrice, en regard des plots de connexion de l'antenne.

Une vue en coupe longitudinale de la feuille de papier transfert, selon l'axe A-A, est représentée sur la figure 2. La feuille de papier transfert 10 porte l'antenne 12 sous forme de spires sérigraphiées. La puce 14 est connectées à l'antenne 12.

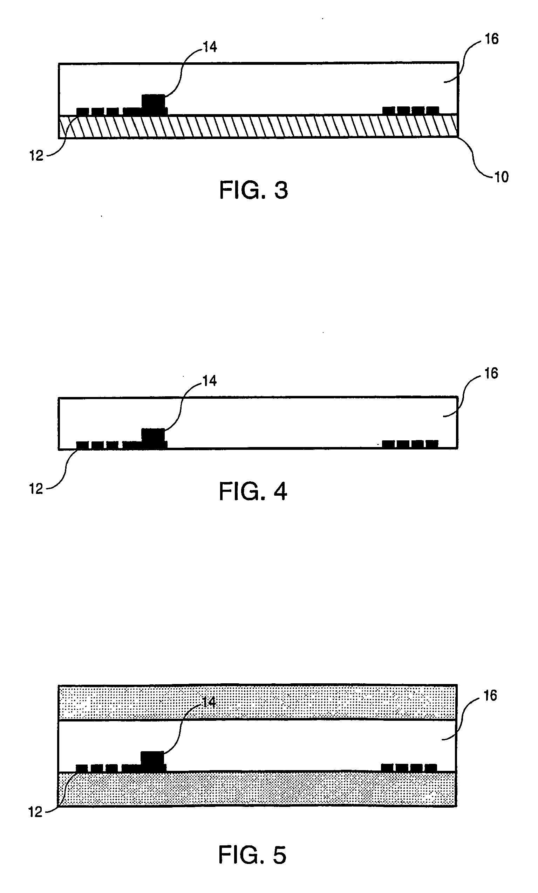

Une fois la puce connectée sur l'antenne, la feuille de papier transfert est laminée avec une feuille de matière plastique constituant le support d'antenne. Cette étape de lamination s'effectue par pressage à chaud. Sur la figure 3, sont représentés la feuille de papier transfert 10 et le support d'antenne 16 en matière plastique. Selon un mode préféré de réalisation, cette matière plastique peut être du PVC ou du PET. On constate sur cette figure 3, qu'une fois l'étape de lamination réalisée, l'antenne sérigraphiée 12 et la puce 14 sont noyées dans la couche de PVC 16 constituant le support d'antenne. Le PVC utilisé pour constituer le support d'antenne possède un point Vicat élevé (température de ramollissement de la matière). En effet, sa température de ramollissement est préférentiellement de 85°C. Lors de l'étape de lamination, le pressage à chaud se fait à une température supérieure ou égale à 85°C, de telle sorte que le PVC se ramollit. Ainsi, la puce et l'antenne s'enfoncent dans la couche de PVC et se retrouvent noyées dans cette dernière.

L'étape suivante consiste à décoller la feuille de papier transfert du support d'antenne en PVC. En effet, la propriété du papier transfert est qu'une fois chauffé, il se décolle en libérant ce qu'il portait à sa surface. Dans le cas présent, l'antenne 12 et la puce 14 restent intégrées dans le support d'antenne 16 en PVC, tel que représenté sur le figure 4.

La dernière étape du procédé consiste à laminer au moins une couche de matière plastique de chaque côté du support d'antenne. Ces couches constituent les corps de carte. Selon un mode de réalisation préféré, cette matière plastique est le PVC, le polyester (PET, PETG), du polycarbonate (PC) ou de l'acrylonitrile-butadiène-styrène (ABS). Préférentiellement la matière plastique utilisée est le PVC. Ce PVC, contrairement à celui utilisé pour le support d'antenne, possède un point Vicat bas. En effet, sa température de ramollissement est préférentiellement de 75°C. Afin d'être solidarisées, les trois couches de PVC sont chauffées et pressées à 75°C. Les couches constituant les corps de carte ramollissent et se fixent au support d'antenne, qui lui, reste dur. Il est donc nécessaire d'utiliser pour le support d'antenne un PVC à haut point Vicat, de manière à éviter que ce dernier ne se ramollisse lorsqu'on lamine les corps de carte à une température correspondant au point Vicat du PVC les constituant. En effet, une déformation du PVC constituant le support d'antenne pourrait entraîner une déformation voire une coupure de l'antenne, ce qui rendrait la carte à puce inutilisable. La température de lamination des corps de carte est donc supérieure ou égale au point Vicat du PVC les constituant, mais inférieure au point Vicat du PVC constituant le support d'antenne.

La carte ainsi obtenue est représentée en coupe longitudinale sur la figure 5. Le support d'antenne 16 comprend l'antenne 12 et la puce 14. Ce support est solidaire de deux corps de carte 18 et 20, de part et d'autre du support 16. On constate que cette architecture confère une grande protection aux organes vitaux de la carte que sont l'antenne et la puce, puisqu'elles sont complètement noyées dans le support d'antenne. De plus, la carte ainsi obtenue ne présente ni surépaisseur, ni artéfacts visuels sur la carte, ni déformations de l'impression qui seraient dus aux composants électroniques.

Ce procédé de fabrication permet donc d'obtenir une carte entièrement en PVC, avec une antenne en encre conductrice sérigraphiée. Cette carte présente donc un coût de revient très faible, malgré une très grande fiabilité, contrairement aux cartes classiques qui sont beaucoup plus coûteuses à fabriquer et qui, de par leur architecture et notamment leur antenne en cuivre filaire ou gravée, sont beaucoup plus fragiles.

## Revendications

1. Procédé de fabrication d'une carte à puce sans contact comportant les étapes suivantes :
- fabrication d'une antenne (12) consistant à sérigraphier des spires d'encre conductrice polymérisable sur une feuille de papier transfert et à faire subir à ladite feuille de papier transfert un traitement thermique de façon à cuire et polymériser ladite encre conductrice,
- connexion d'une puce (14), munie de plots de connexions, sur ladite antenne (12),
- lamination de ladite feuille de papier transfert avec une couche de matière plastique (16) constituant le support d'antenne, par pressage à chaud, de façon à ce que ladite antenne 12) et ladite puce (14) soit noyées dans ladite couche de matière plastique (16),
- décollage dudit papier transfert, et
- lamination de corps de carte sur ledit support d'antenne, consistant à souder ou à coller de chaque côté dudit support au moins une couche de matière plastique (18, 20) par pressage à chaud.

2. Procédé selon la revendication 1, dans lequel l'étape de connexion de la puce sur ladite antenne consiste à _{:}
- positionner la puce sur la feuille de papier transfert de manière à ce que les plots de connexion de ladite puce soient en regard des plots de connexion de l'antenne, et
- exercer une pression sur ladite puce de façon à ce que lesdits plots de connexion déforment ladite feuille de papier transfert et lesdits plots de connexion de ladite antenne sous l'effet de la pression, ladite feuille de papier transfert et lesdits plots conservant leur déformation après que la pression a cessé d'être exercée, permettant ainsi d'obtenir une surface de contact importante entre les plots de connexion de la puce et les plots de connexion de l'antenne.

3. Procédé selon la revendication 1, dans lequel l'étape de connexion de la puce sur ladite antenne consiste à :
- enduire les plots de connexion de l'antenne d'une colle conductrice et
- positionner la puce sur la feuille de papier transfert de manière à ce que les plots de connexion de ladite puce viennent baigner dans ladite colle conductrice, en regard des plots de connexion de l'antenne.

4. Procédé selon l'une des revendications précédentes, dans lequel ledit support d'antenne est en matière plastique notamment en PVC à haut point Vicat ou en PET.

5. Procédé selon la revendication 4, dans lequel le point Vicat est 85°C.

6. Procédé selon l'une des revendications précédentes, dans lequel la matière plastique constituant les corps de carte est du polychlorure de vinyle (PVC), du polyester (PET, PETG), du polycarbonate (PC) ou de l'acrylonitrile-butadiène-styrène (ABS).

7. Procédé selon la revendication 6, dans lequel ladite matière plastique est du PVC à bas point Vicat.

8. Procédé selon la revendication 7, dans lequel le point Vicat est 75°C.

9. Procédé selon l'une des revendications 4 à 8, dans lequel ladite étape de lamination du papier transfert sur le support d'antenne est réalisée à une température supérieure ou égale au point Vicat du PVC constituant ledit support d'antenne.

10. Procédé selon l'une des revendications 7 à 9, dans lequel ladite étape de lamination des corps de carte est réalisée à une température supérieure ou égale au point Vicat du PVC constituant lesdits corps de carte, mais inférieure au point Vicat du PVC constituant ledit support d'antenne.

11. Procédé selon l'une des revendications précédentes, dans lequel ladite encre conductrice polymérisable est une encre époxy chargée en éléments conducteurs tels que des particules d'argent, de cuivre ou de carbone.

## Claims

1. A manufacturing method for a contactless smart card, including the following steps:
- creation of an antenna (12) by screen printing turns of an electrically conductive polymer ink onto a transfer paper sheet, and then subjecting said transfer paper sheet to heat treatment in order to bake and polymerize said conductive ink,
- connection of a chip (14), provided with contacts, to said antenna (12),
- lamination of said transfer paper sheet with a layer of plastic material (16) which constitutes the support for the antenna, by hot press molding, in such a way that said antenna (12) and said chip (14) are both embedded within said layer of plastic material (16),
- removal of said transfer paper, and
- lamination of the card body onto said antenna support by welding or sticking on either side of the support at least one layer of plastic material (18, 20) by means of hot press molding.

2. The method according to claim 1, in which the step of connecting the chip to said antenna consists in:
- positioning the chip on the transfer paper in such a way that the contacts of said chip are located opposite the antenna's contacts, and
- exerting pressure on said chip in such a way that said contacts deform said transfer paper and said contacts of said antenna as a result of the pressure, the deformation of said transfer paper sheet and said contacts persisting after the pressure has been lifted, thus providing an extensive area of contact between the contacts on the chip and those on the antenna.

3. The method according to claim 1, in which the step of connecting the chip to said antenna consists in:
- coating the antenna's contacts with a conductive adhesive, and
- positioning the chip on the transfer paper in such a way that the contacts of said chip become embedded in said conductive adhesive opposite the antenna's contacts.

4. The method according to any of the previous claims in which said antenna support is made of a plastic material, notably PVC with a high Vicat point or PET.

5. The method according to claim 4 in which the Vicat point is 85° C.

6. The method according to any of the previous claims, in which the plastic material forming the card body is polyvinyl chloride (PVC), polyester (PET, PETG), polycarbonate (PC) or acrylonitrile-butadiene-styrene (ABS).

7. The method according to claim 6 in which said plastic material is PVC with a low Vicat point.

8. The method according to claim 7 in which the Vicat point is 75° C.

9. The method according to any of claims 4 through 8 in which the temperature at which said step of lamination of the transfer paper onto the antenna's support is performed is equal to or greater than the Vicat point of the PVC used to make said antenna support

10. The method according to any of claims 7 through 9 in which the temperature at which said step of lamination of the card bodies is performed is equal to or greater than the Vicat point of the PVC used to make said card bodies, but below the Vicat point of the PVC used to make said antenna support.

11. The method according to any of the previous claims in which said polymerizable, conductive ink is an epoxy ink doped with conductive elements such as particles of silver, copper or carbon.

## Patentansprüche

1. Verfahren zur Herstellung einer kontaktlosen Chipkarte, das die folgenden Schritte aufweist:
- Herstellung einer Antenne (12), die darin besteht, Spiralen polymerisierbarer leitender Farbe durch Siebdruck auf ein Transferpapierblatt aufzubringen und das Transferpapierblatt einer Wärmebehandlung zu unterziehen, um die leitende Farbe zu brennen und zu polymerisieren,
- Anschluss eines mit Anschlusskontakten versehenen Chips (14) an die Antenne (12),
- Laminieren des Transferpapierblatts mit einer den Antennenträger bildenden Kunststoffschicht (16) durch Heißpressen, damit die Antenne (12) und der Chip (14) in die Kunststoffschicht (16) eingebettet werden,
- Ablösen des Transferpapiers, und
- Laminieren von Kartenkörpern auf den Antennenträger, das darin besteht, auf jede Seite des Trägers mindestens eine Kunststoffschicht (18, 20) durch Heißpressen zu schweißen oder zu kleben.

2. Verfahren nach Anspruch 1, bei dem der Anschlussschritt des Chips an die Antenne darin besteht:
- den Chip so auf dem Transferpapierblatt zu positionieren, dass die Anschlusskontakte des Chips sich gegenüber den Anschlusskontakten der Antenne befinden, und
- einen Druck auf den Chip auszuüben, damit die Anschlusskontakte das Transferpapierblatt und die Anschlusskontakte der Antenne unter der Wirkung des Drucks verformen, wobei das Transferpapierblatt und die Kontakte nach dem Ende des Drucks ihre Verformung beibehalten, wodurch es ermöglicht wird, eine große Kontaktfläche zwischen den Anschlusskontakten des Chips und den Anschlusskontakten der Antenne zu erhalten.

3. Verfahren nach Anspruch 1, wobei der Anschlussschritt des Chips an die Antenne darin besteht:
- die Anschlusskontakte der Antenne mit einem leitenden Klebstoff zu bestreichen, und
- den Chip so auf dem Transferpapierblatt zu positionieren, dass die Anschlusskontakte des Chips gegenüber den Anschlusskontakten der Antenne in den leitenden Klebstoff eingetaucht werden.

4. Verfahren nach einem der vorhergehenden Ansprüche, wobei der Antennenträger aus Kunststoff, insbesondere PVC mit hohem Vicat-Punkt, oder aus PET ist.

5. Verfahren nach Anspruch 4, wobei der Vicat-Punkt 85°C beträgt.

6. Verfahren nach einem der vorhergehenden Ansprüche, wobei der die Kartenkörper bildende Kunststoff Polyvinylchlorid (PVC), Polyester (PET, PETG), Polycarbonat (PC) oder Acrylnitril-Butadien-Styrol (ABS) ist.

7. Verfahren nach Anspruch 6, wobei der Kunststoff PVC mit niedrigem Vicat-Punkt ist.

8. Verfahren nach Anspruch 7, wobei der Vicat-Punkt 75°C beträgt.

9. Verfahren nach einem der Ansprüche 4 bis 8, wobei der Schritt der Laminierung des Transferpapiers auf den Antennenträger bei einer Temperatur höher als der oder gleich dem Vicat-Punkt des den Antennenträger bildenden PVCs durchgeführt wird.

10. Verfahren nach einem der Ansprüche 7 bis 9, wobei der Schritt der Laminierung der Kartenkörper bei einer Temperatur höher als der oder gleich dem Vicat-Punkt des die Kartenkörper bildenden PVCs, aber niedriger als der Vicat-Punkt des den Antennenträger bildenden PVCs durchgeführt wird.

11. Verfahren nach einem der vorhergehenden Ansprüche, wobei die polymerisierbare leitende Farbe eine Epoxidfarbe ist, die mit leitenden Elementen wie Silber-, Kupfer- oder Kohlenstoffteilchen angereichert ist.
